# FASCICULE DE BREVET EUROPEEN

(11) **EP 0 518 790 B1**
(45) Date de publication et mention de la délivrance du brevet: **03.12.1997**
(21) Numéro de dépôt: 92420195.7
(22) Date de dépôt: 09.06.1992
(51) Int. Cl.: H02H 9/04, H01L 29/86

(54) **Composant de protection bidirectionnel**
Bidirektionales Schutzelement
Bidirectional protection element

(30) Priorité: 11.06.1991 FR 9107478
(43) Date de publication de la demande: 16.12.1992
(73) Titulaire: SGS-THOMSON MICROELECTRONICS S.A., 94250 Gentilly (FR)
(72) Inventeur: Pezzani, Robert, F-37210 Vouvray (FR)
(74) Mandataire: de Beaumont, Michel

(56) Documents cités:
- WO-A-82/02287
- FR-A- 2 433 845

## Description

La présente invention concerne un dispositif de protection bidirectionnel et plus particulièrement un tel dispositif réalisé sous forme monolithique.

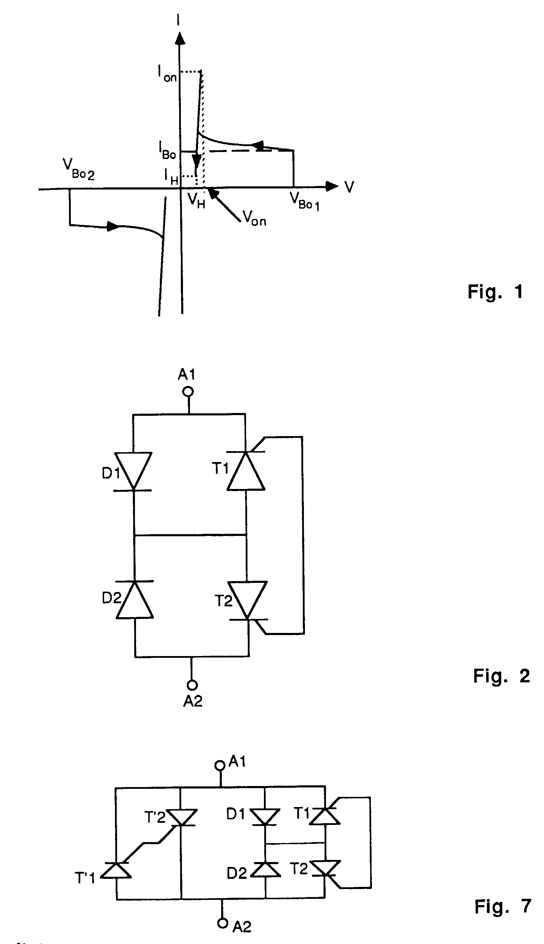

La figure 1 illustre la caractéristique courant-tension d'un composant de protection bidirectionnel. Si l'on considère le quadrant positif de cette caractéristique, quand la tension aux bornes du composant atteint une valeur V_{B01}, le courant commence par croître rapidement à tension sensiblement constante puis, brutalement, la tension aux bornes du composant chute tandis que le courant croît. La valeur du courant se stabilise en fonction de l'impédance série du circuit à une valeur I_{ON} pour laquelle la tension aux bornes du composant a une valeur faible V_{ON}. Quand la tension aux bornes du composant décroît, le courant diminue jusqu'à une valeur de courant de maintien I_{H} correspondant à une valeur de tension V_{H}. En dessous de cette valeur I_{H}, le composant est à nouveau à l'état bloqué.

Dans le quadrant négatif, le composant présente une caractéristique similaire.

Il existe déjà de nombreux composants présentant de telles caractéristiques. En particulier, le document WO-A-82/02287 décrit un composant ayant une structure conforme au préambule de la revendication 1, dans lequel les gâchettes des deux thyristors sont connectées à l'un ou l'autre de deux potentiels de référence qui déterminent le déclenchement des thyristors.

On s'intéresse plus particulièrement ici à un composant présentant un faible courant de maintien, non supérieur à quelques milliampères, une tension de retournement non supérieure à quelques dizaines de volts, un courant maximum I_{BO} pour la tension de retournement non supérieur à quelques milliampères. On souhaite de plus obtenir un composant tel que la chute de tension à l'état passant, V_{ON}, soit particulièrement faible pour de faibles valeurs du courant à l'état passant I_{ON}. On vise aussi à réaliser un composant dans lequel les tensions de claquage positive V_{BO1} et négative V_{BO2} puissent être réglées indépendamment.

Pour atteindre ces objets, la présente invention prévoit un composant de protection bidirectionnel comprenant deux thyristors tête-bêche dont chacun est en anti-parallèle avec une diode, dans lequel les gâchettes des deux thyristors sont interconnectées tel que défini par la revendication 1.

Selon un mode de réalisation de la présente invention, le composant de protection bidirectionnel réalisé sous forme monolithique comprend l'association de deux thyristors verticaux de même orientation et de deux diodes verticales de même orientation, opposée à celle des thyristors. Les régions semiconductrices constituant les thyristors sont communes à l'exception de leurs régions de cathode. Ce composant comprend trois métallisations : une métallisation de face arrière reliant les anodes communes des thyristors aux cathodes des diodes, une première métallisation de face avant reliant la cathode d'un thyristor à l'anode d'une diode, et une deuxième métallisation de face avant reliant la cathode de l'autre thyristor à l'anode de l'autre diode.

Selon un autre mode de réalisation de la présente invention, le composant de protection bidirectionnel réalisé sous forme monolithique comprend l'association de deux thyristors verticaux de même orientation et de deux diodes latérales de même orientation, opposée à celle des thyristors. Les régions semiconductrices constituant les thyristors sont communes, à l'exception de leurs régions de cathode, ce composant comprenant quatre métallisations : une métallisation de face arrière, une première métallisation de face avant reliant la cathode d'un thyristor à l'anode d'une diode, une deuxième métallisation de face avant reliant la cathode de l'autre thyristor à l'anode de l'autre diode, et une troisième métallisation de face avant en contact avec la région d'anode des diodes, cette troisième métallisation de face avant étant destinée à être reliée à la métallisation de face arrière.

Selon un mode de réalisation de la présente invention, les régions de cathode distinctes des deux thyristors présentent des niveaux de dopage distincts.

Selon un mode de réalisation de la présente invention, la région d'anode de la première diode, respectivement de la deuxième diode, connectée à la région de cathode du premier thyristor, respectivement du deuxième thyristor comprend un prolongement en regard de la région de cathode du deuxième, respectivement du premier, thyristor.

Selon un mode de réalisation du composant à diodes verticales :
les thyristors verticaux comprennent, à partir de la face arrière de la plaquette, une première région commune d'un premier type de conductivité, une deuxième région commune du deuxième type de conductivité, une troisième région commune du premier type de conductivité, et des premières régions distinctes du deuxième type de conductivité affleurant la face avant ;
les diodes verticales comprennent, de la face arrière vers la face avant, une quatrième région commune du deuxième type de conductivité, la deuxième région commune et des deuxièmes régions distinctes du premier type de conductivité ; et
des métallisations de face avant relient une région distincte d'un thyristor à une région distincte d'une diode et l'autre région distincte d'un thyristor à l'autre région distincte d'une diode, et une métallisation de face arrière relie les première et quatrième régions communes.

Selon un mode de réalisation du composant à diodes latérales :
les thyristors verticaux comprennent, à partir de la face arrière de la plaquette, une première région commune du premier type de conductivité, une deuxième région commune du deuxième type de conductivité, une troisième région commune du premier type de conductivité, et des régions distinctes du deuxième type de conductivité affleurant la surface avant ;
les diodes latérales comprennent, du côté de la face avant, une quatrième région commune du deuxième type de conductivité à niveau de dopage élevé et des régions distinctes du premier type de conductivité formées dans la deuxième région commune ;
des premières métallisations de face avant relient une région distincte d'un thyristor à une région distincte d'une diode et l'autre région distincte d'un thyristor à l'autre région distincte d'une diode ;
une deuxième métallisation est formée sur la quatrième région commune ; et
une métallisation de face arrière est prévue pour être connectée à la deuxième métallisation.

Ces objets, caractéristiques et avantages de la présente invention seront plus exposés plus en détail dans la description suivante de modes de réalisation particuliers faite en relation avec les dessins joints parmi lesquels :
la figure 1 représente la courbe caractéristique d'un composant de protection bidirectionnel ;
la figure 2 représente le schéma équivalent d'un composant de protection bidirectionnel selon l'invention ;
les figures 3A, 3B et 3C représentent, respectivement en vue de dessus et selon deux vues en coupe, un mode de réalisation d'un composant monolithique selon la présente invention ;
les figures 4A, 4B et 4C représentent, respectivement en vue de dessus et selon deux vues en coupe, un autre mode de réalisation d'un composant monolithique selon la présente invention ;
les figures 5A, 5B et 5C représentent, respectivement en vue de dessus et selon deux vues en coupe, un autre mode de réalisation d'un composant monolithique selon la présente invention ;
les figures 6A, 6B et 6C représentent, respectivement en vue de dessus et selon deux vues en coupe, un autre mode de réalisation d'un composant monolithique selon la présente invention ; et
la figure 7 représente le schéma équivalent d'un composant monolithique tel que celui des figures 5 ou 6.

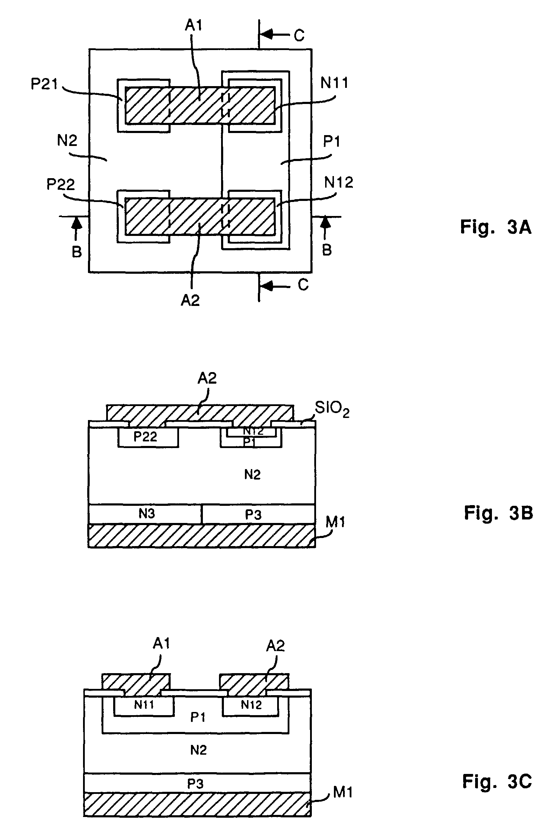

Les figures 3 à 6, conformément à l'usage dans le domaine de la représentation des semiconducteurs, ne sont pas tracées à l'échelle ni à l'intérieur d'une figure donnée, ni d'une figure à l'autre. De plus, les formes des diverses régions sont fortement schématiques. Notamment, elles sont représentées à coins carrés alors que, en pratique, les divers coins seront arrondis comme cela résulte des étapes de diffusion et de recuit. De plus, dans les figures, de mêmes références numériques désignent des couches ou régions similaires ou analogues.

Comme le représente la figure 2, un composant de protection selon la présente invention, destiné à dériver des surtensions susceptibles d'apparaître entre des bornes A1 et A2, comprend deux thyristors tête-bêche à gâchette de cathode T1 et T2. Chacun des thyristors est monté en anti-parallèle avec une diode respective D1, D2. Les gâchettes des thyristors T1 et T2 sont interconnectées.

Supposons qu'une surtension positive apparaisse à la borne A1. Tant que cette surtension est faible, les deux thyristors T1 et T2 sont bloqués et aucun courant ne circule. Quand la tension sur la borne A1 dépasse la tension d'avalanche de la diode en inverse cathode-gâchette du thyristor T1 (plus la tension de la diode gâchette-cathode en direct du thyristor T2), un courant circule dans la gâchette du thyristor T2 et ce thyristor devient passant. La surtension positive s'écoule alors de la borne A1 vers la borne A2 en passant par la diode D1 et le thyristor T2. De façon similaire, une surtension négative s'écoulera par le thyristor T1 et la diode D2.

Etant donné les objets de la présente invention, on choisira pour chacun des thyristors T1 et T2 un thyristor sensible, c'est-à-dire un thyristor sans court-circuits d'émetteur gâchette-cathode.

La figure 3A illustre une vue de dessus schématique d'un mode de réalisation monolithique d'un composant selon la présente invention. Les figures 3B et 3C sont respectivement des vues en coupe selon les lignes B-B et C-C de la figure 3A. Dans ce mode de réalisation, les thyristors et les diodes sont de type vertical. Les thyristors comprennent une région commune de gâchette ou d'émetteur, Pl, formées dans un substrat de type N, N2, au-dessus d'une couche d'anode P3. La région de cathode de type N, respectivement N11 et N12, de chacun des thyristors T1 et T2 est formée dans la région d'émetteur P1. La face inférieure est solidaire d'une métallisation M1. Chacune des diodes D1 et D2 comprend du côté de la face supérieure une région d'anode, respectivement P21 et P22, formée dans la couche N2 et, du côté de la face arrière, une région de type N plus fortement dopée N3. On a donc bien obtenu le thyristor T1 constitué des régions N11, P1, N2 et P3, le thyristor T2 constitué des régions N12, P1, N2 et P3, la diode D1 constituée des régions P21, N2 et N3 et la diode D2 constituée des régions P22, N2 et N3. Si les régions N11 et N12 sont différemment dopées, les tensions de claquage des jonctions N11P1 et N12P1 seront distinctes et l'on pourra donc régler séparément les tensions de claquage pour les surtensions positives et négatives. Une métallisation A1 relie les faces supérieures des régions N11 et P21 et une métallisation A2 relie les faces supérieures des régions N12 et P22. En d'autres termes, la métallisation A1 relie l'anode de la diode D1 à la cathode du thyristor T1 et la métallisation A2 relie l'anode de la diode D2 à la cathode du thyristor T2. La métallisation M1 relie les anodes des thyristors aux cathodes des diodes. La liaison entre les gâchettes des deux thyristors est constituée par la région P1 commune. Le composant de la figure 3 correspond donc bien au schéma équivalent de la figure 2.

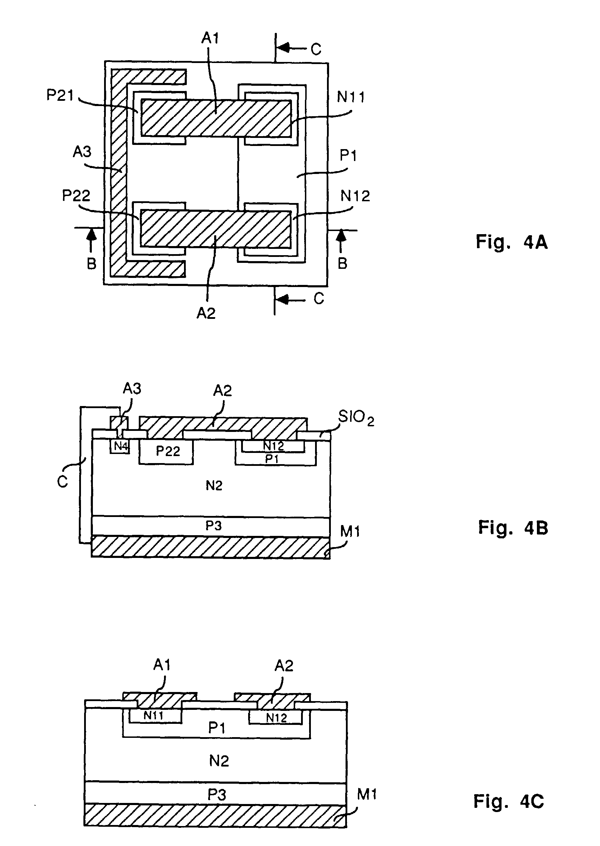

Les figures 4A à 4C représentent respectivement une vue de dessus, une vue en coupe selon la ligne B-B de la figure 4A et une vue en coupe selon la ligne C-C de la figure 4A d'un deuxième mode de réalisation de la présente invention.

Dans le deuxième mode de réalisation, comme dans le premier, les thyristors T1 et T2 sont de type vertical mais cette fois-ci les diodes D1 et D2 sont de type latéral.

Comme on le notera en comparant les figures 4A à 4C aux figures 3A à 3C, la différence entre les deux modes de réalisation est que, dans le deuxième mode de réalisation, la face inférieure du substrat est revêtue d'une couche P uniforme, P3, et que la couche N3 précédemment illustrée en figure 3B n'apparaît plus. Par contre, une région diffusée de type N, N4, revêtue d'une métallisation A3 longe les régions P21 et P22. Il en résulte que les diodes D1 et D2 sont respectivement constituées par les régions P21, N2, N4 et P22, N2, N4, ces diodes étant respectivement formées entre les métallisations A1-A3 et A2-A3. Pour relier les cathodes des diodes (N4) aux anodes des thyristors (P3), il conviendra de prévoir une connexion externe C entre la métallisation A3 et la métallisation M1, comme cela est représenté symboliquement en figure 4B.

Ce deuxième mode de réalisation, qui constitue un aspect de l'invention, présente de nombreux avantages par rapport au premier mode de réalisation. Il est de réalisation plus simple puisque seule la face supérieure de la structure sera soumise à des étapes de photolithogravure, la face inférieure étant traitée de façon uniforme. Cette structure pourra être réalisée à partir d'une plaquette de silicium dont le substrat est constituée par la région P3 et sur laquelle la région N2 est formée par épitaxie, ce qui permet l'utilisation de plaquettes plus épaisses et l'emploi de plaquettes de plus fort diamètre car, du fait de leurs épaisseurs, elles sont moins fragiles. Enfin, comme cela est connu, du fait que l'étendue de la région N2 entre les régions P22 et N4 est plus faible dans le mode de réalisation de la figure 4 que l'épaisseur de la région N2 entre les régions P22 et N3 dans le cas de la figure 3B, les diodes latérales selon ce deuxième mode de réalisation présenteront une plus faible surtension à la mise en conduction que les diodes verticales du premier mode de réalisation.

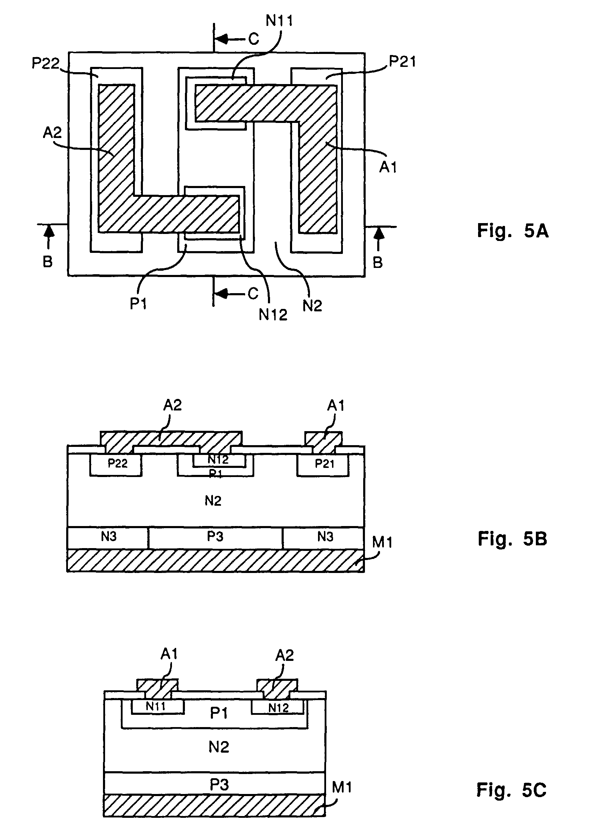

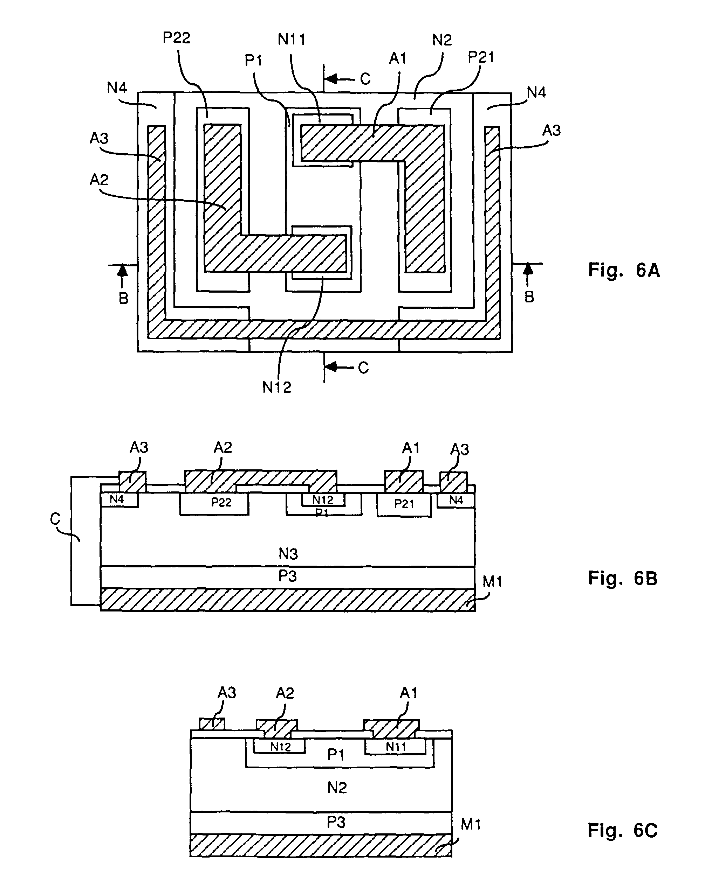

Les figures 5 et 6 illustrent une modification apportée respectivement au mode de réalisation illustré en figure 3 et au mode de réalisation illustré en figure 4. Cette modification constitue un aspect de la présente invention.

Cette autre réalisation de l'invention se différencie des réalisations précédentes non pas dans les vues en coupe (les figures 5B, 5C d'une part et 6B, 6C d'autre part sont respectivement très semblables aux figures 3B, 3C d'une part et 4B, 4C d'autre part) mais par leur implantation telle qu'on la voit dans les vues de dessus des figures 5A et 6A.

Plus particulièrement, cet aspect de la présente invention réside dans la prévision d'un prolongement des régions d'anode P21 et P22 des diodes D1 et D2 en regard de la région de gâchette (région P1) du thyristor auquel chacune de ces diodes n'est pas connectée. Ainsi, la région P22 de la diode D2 se prolonge en face de la région P1 correspondant au thyristor T1 et la région P21 de la diode D1 se prolonge en face de la région P1 correspondant au thyristor T1. En conséquence, comme le représentent les figures 5B et 6B, en plus de la connexion en série du thyristor T2 et de la diode D2, il apparaît entre les bornes A2 et A1 un thyristor latéral T'2 formé par la région N12, la région P1, la région N2 et la région P21. Ce thyristor T'2 a la même orientation que le thyristor T2 en série avec la diode D1. De même, un thyristor latéral T'1 constitué des régions N11, P1, N2 et P22 apparaît entre les électrodes A1 et A2 avec la même polarité que le thyristor T1 en série avec la diode D2.

Le schéma équivalent des circuits des figures 5 et 6 est celui représenté en figure 7. On retrouve dans ce schéma équivalent l'ensemble des éléments D1, D2, T1, T2 connectés comme en figure 2 mais auquel s'ajoutent les thyristors T'1 et T'2 connectés en anti-parallèle entre les bornes A1 et A2, les gâchettes de ces thyristors T'1 et T'2 étant reliées. La région de gâchette commune des thyristors T'1 et T'2 est à nouveau la région P1.

Les thyristors latéraux T'1 et T'2 deviennent passants respectivement en même temps que les thyristors verticaux T1 et T2. Ils présentent l'avantage que, quand le courant entre les bornes A1 et A2 est faible, à l'état passant, la chute de tension à leurs bornes est plus faible que la chute de tension aux bornes de la connexion en série d'une diode et d'un thyristor (D1 et T2 ou D2 et T1). Par contre, quand le courant est élevé, ces thyristors latéraux présenteront une plus forte résistance à l'état passant que les thyristors T1 et T2 et le courant tendra à s'établir préférentiellement dans la connexion série de la diode D2 et du thyristor T1 ou de la diode D1 et du thyristor T2 selon le sens de la surtension. Ainsi, un dispositif de protection constitué selon cet aspect de la présente invention présente l'avantage de pouvoir absorber de fortes surcharges grâce aux thyristors T1 et T2 et de pouvoir présenter une très faible chute de tension E pour de faibles courants grâce aux thyristors T'1 et T'2.

Bien entendu, la présente invention est susceptible de nombreuses variantes et modifications qui apparaîtront à l'homme de l'art, notamment en ce qui concerne la configuration en vue de dessus des diverses couches. Par exemple, en figure 4A, on pourrait envisager que la métallisation A3 fasse tout le tour du composant. Dans les diverses figures, on pourrait prévoir diverses digitations des formes des diverses couches pour favoriser l'interaction entre les différents éléments. En figure 6A, on a représenté la diffusion N4 comme interrompue en bas de la figure. Cette diffusion N4 pourrait se prolonger. Elle pourrait aussi être symétrique tout autour du composant. De même, l'homme de l'art saura choisir les surfaces relatives des diverses régions et les valeurs de ces surfaces ainsi que les niveaux de diffusion pour obtenir des caractéristiques préférées de tension de déclenchement et de capacité d'absorption de puissance.

A titre d'exemple, on pourra, dans le mode de réalisation de la figure 6, choisir pour les diverses régions les valeurs approximatives suivantes de niveau de dopage, de concentration superficelle (Cₛ), ou de résistivité :

| | |
|---|---|
| substrat P3 | concentration supérieure à 10¹⁸ at/cm³ |
| région épitaxiée N2 | résistivité de quelques ohms.cm |
| diffusions P1, P21 et P22 | Cₛ = 10¹⁸ at/cm³ |
| diffusion N12 | Cₛ = 10²⁰ at/cm³ |
| diffusion N22 | Cₛ = 2 10²⁰ at/cm³ |
| diffusion N4 | Cₛ = 10²⁰ at/cm³ |

Avec ces niveaux de dopage, le composant de protection présentera les caractéristiques suivantes :

| | |
|---|---|
| VB01 (dans le sens positif) | 18 V |
| VB02 (dans le sens négatif) | 15 V |
| V_{ON} (pour I_{ON} = 10 mA) | inférieur à 1 V |
| V_{ON} (pour I_{ON} = 10 A) | inférieur à 3 V |
| I_{H} | inférieur à 1 mA |
| I_{BO} | inférieur à 1 mA |

## Revendications

1. Composant de protection bidirectionnel entre deux bornes (A1, A2) comprenant, entre ces bornes, deux thyristors (T1, T2) en série et en opposition dont chacun est en anti-parallèle avec une diode (D1, D2), et dont les gâchettes sont interconnectées, caractérisé en ce qu'un premier des thyristors (T1) devient passant quand la tension aux bornes des deux thyristors dépasse la somme de la tension d'avalanche de la diode gâchette-cathode en inverse du deuxième des deux thyristors (T2) plus la tension de la diode gâchette-cathode en direct du premier thyristor (T1) et vice-versa.

2. Composant de protection bidirectionnel monolithique selon la revendication 1, dans lequel les deux thyristors (T1, T2) et les deux diodes (D1, D2) sont de type vertical, caractérisé en ce que les régions semiconductrices constituant les thyristors ( P3, N2, P1) sont communes à l'exception de leurs régions de cathode (N11, N12), ce composant comprenant trois métallisations : une métallisation de face arrière (M1) reliant les anodes communes des thyristors aux cathodes des diodes, une première métallisation de face avant (A1) reliant la cathode (N11) d'un thyristor à l'anode (P21) d'une diode, et une deuxième métallisation de face avant (A2) reliant la cathode (N12) de l'autre thyristor à l'anode (P22) de l'autre diode.

3. Composant de protection bidirectionnel monolithique selon la revendication 1, dans lequel les deux thyristors (T1, T2) sont de type vertical, et les deux diodes (D1, D2) de type latéral, caractérisé en ce que les régions semiconductrices constituant les thyristors sont communes, à l'exception de leurs régions de cathode (N11, N12), ce composant comprenant quatre métallisations : une métallisation de face arrière (M1), une première métallisation de face avant (A1) reliant la cathode d'un thyristor à l'anode d'une diode, une deuxième métallisation de face avant (A2) reliant la cathode de l'autre thyristor à l'anode de l'autre diode, et une troisième métallisation de face avant (A3) en contact avec la région d'anode des diodes, cette troisième métallisation de face avant étant destinée à être reliée à la métallisation de face arrière.

4. Composant de protection bidirectionnel selon l'une des revendications 2 ou 3, caractérisé en ce que les régions de cathode distinctes des deux thyristors présentent des niveaux de dopage distincts.

5. Composant de protection bidirectionnel selon l'une des revendications 2 ou 3, caractérisé en ce que la région d'anode (P21) de la première diode, respectivement de la deuxième diode (P22), connectée à la région de cathode (N11) du premier thyristor (T1), respectivement du deuxième thyristor (T2), comprend un prolongement en regard de la région de cathode (N12) du deuxième, respectivement du premier, thyristor.

6. Composant de protection bidirectionnel selon la revendication 2, caractérisé en ce que :
les thyristors verticaux (T1, T2) comprennent, à partir de la face arrière de la plaquette, une première région commune (P3) d'un premier type de conductivité, une deuxième région commune (N2) du deuxième type de conductivité, une troisième région commune (P1) du premier type de conductivité et, des premières régions distinctes (N11, N12) du deuxième type de conductivité affleurant la face avant ;
les diodes verticales comprennent, de la face arrière vers la face avant, une quatrième région commune (N3) du deuxième type de conductivité, la deuxième région commune (N2) et des deuxièmes régions distinctes (P21, P22) du premier type de conductivité ; et
des métallisations de face avant (A1 et A2) relient une région distincte d'un thyristor à une région distincte d'une diode et l'autre région distincte d'un thyristor à l'autre région distincte d'une diode, et une métallisation de face arrière (M1) relie les première et quatrième régions communes.

7. Composant de protection bidirectionnel monolithique selon la revendication 3, caractérisé en ce que :
les thyristors verticaux (T1, T2) comprennent, à partir de la face arrière de la plaquette, une première région commune (P3) du premier type de conductivité, une deuxième région commune (N2) du deuxième type de conductivité, une troisième région commune (P1) du premier type de conductivité et, des régions distinctes (N11, N12) du deuxième de conductivité affleurant la surface avant ;
les diodes latérales comprennent, du côté de la face avant, une quatrième région commune (N4) du deuxième type de conductivité à niveau de dopage élevé et des régions distinctes (P21, P22) du premier type de conductivité formées dans la deuxième région commune (N2) ;
des premières métallisations de face avant (A1, A2) relient une région distincte d'un thyristor à une région distincte d'une diode et l'autre région distincte d'un thyristor à l'autre région distincte d'une diode ;
une deuxième métallisation est formée sur la quatrième région commune ; et
une métallisation de face arrière est prévue pour être connectée à la deuxième métallisation.

## Patentansprüche

1. Bidirektionales Schutzbauteil zwischen zwei Anschlüssen (Al, A2), welches zwischen diesen Anschlüssen zwei Thyristoren (T1, T2) in Reihe miteinander und entgegengesetzt gepolt aufweist, deren jeder in Antiparallelschaltung mit einer Diode (D1, D2) angeordnet ist und deren Gates miteinander verbunden sind,
dadurch gekennzeichnet, daß ein erster (T1) der Thyristoren leitend wird, sobald die Spannung an den Anschlüssen der beiden Thyristoren die Summe aus der Durchbruchspannung der in Sperrichtung gepolten Gate-Kathoden-Diode des zweiten (T2) der beiden Thyristoren und der Spannung der Gate-Kathoden-Diode in Durchlaßrichtung des ersten Thyristors (T1) und umgekehrt übersteigt.

2. Monolithisches bidirektionales Schutzbauteil nach Anspruch 1, in welchem die beiden Thyristoren (T1, T2) und die beiden Dioden (D1, D2) vom Vertikal-Typ sind,
dadurch gekennzeichnet, daß die die Thyristoren bildenden Halbleiterbereiche (P3,N2,P3) mit Ausnahme ihrer Kathodenbereiche (N11, N12) gemeinsam sind, wobei dieses Bauteil drei Metallisierungen aufweist: eine rückseitige Flächenmetallisierung (M1), welche die gemeinsamen Anoden der Thyristoren mit den Kathoden der Dioden verbindet, eine erste Vorderseitenmetallisierung (Al), welche die Kathode (N11) eines Thyristors mit der Anode (P21) einer Diode verbindet, sowie eine zweite Vorderseitenmetallisierung (A2), welche die Kathode (N12) des anderen Thyristors mit der Anode (P22) der anderen Diode verbindet.

3. Monolithisches bidirektionales Schutzbauteil nach Anspruch 1, in welchem die beiden Thyristoren (T1, T2) Vertikalthyristoren und die beiden Dioden (D1, D2) Lateraldioden sind,
dadurch gekennzeichnet, daß die die Thyristoren bildenden Halbleiterbereiche mit Ausnahme ihrer Kathodenbereiche (N11, N12) gemeinsam sind, wobei das Bauteil vier Metallisierungen aufweist: eine rückseitige Oberflächenmetallisierung (M1), eine erste Vorderseitenmetallisierung (Al), welche die Kathode eines Thyristors mit der Anode einer Diode verbindet, eine zweite Vorderseitenmetallisierung (A2), welche die Kathode des anderen Thyristors mit der Anode der anderen Diode verbindet, sowie eine dritte Vorderseitenmetallisierung (A3) in Kontakt mit dem Anodenbereich der Dioden, wobei diese dritte Vorderseitenmetallisierung zur Verbindung mit der Rückseitenmetallisierung bestimmt ist.

4. Bidirektionales Schutzbauteil nach einem der Ansprüche 2 oder 3,
dadurch gekennzeichnet, daß die gesonderten distinkten Kathodenbereiche der beiden Thyristoren gesonderte distinkte Dotierungspegel aufweisen.

5. Bidirektionales Schutzbauteil nach einem der Ansprüche 2 oder 3,
dadurch gekennzeichnet, daß der mit dem Kathodenbereich (N11) des ersten Thyristors (T1) bzw. des zweiten Thyristors (T2) verbundene Anodenbereich (P21) der ersten Diode bzw. der zweiten Diode (P22) eine mit dem Kathodenbereich (N12) des zweiten bzw. des ersten Thyristors ausgerichtete Verlängerung aufweist.

6. Bidirektionales Schutzbauteil nach Anspruch 2, dadurch gekennzeichnet, daß:
- die Vertikalthyristoren (T1, T2), ausgehend von der Plättchenrückseite, aufweisen: einen ersten gemeinsamen Bereich (P3) von einem ersten Leitfähigkeitstyp, einen zweiten gemeinsamen Bereich (N2) von einem zweiten Leitfähigkeitstyp, einen dritten gemeinsamen Bereich (P1) vom ersten Leitfähigkeitstyp und gesonderte, an der Vorderseite freiliegende erste Bereiche (N11, N12) vom zweiten Leitfähigkeitstyp;
- die beiden Vertikaldioden, von der Rückseite zur Vorderseite, aufweisen: einen vierten gemeinsamen Bereich (N3) vom zweiten Leitfähigkeitstyp, den zweiten gemeinsamen Bereich (N2) und zweite gesonderte Bereiche (P21, P22) vom ersten Leitfähigkeitstyp; und
- Vorderseitenmetallisierungen (Al und A2) einen distinkten gesonderten Bereich eines Thyristors mit einem distinkten gesonderten Bereich einer Diode und den anderen gesonderten distinkten Bereich eines Thyristors mit dem anderen distinkten gesonderten Bereich einer Diode verbinden, und daß eine Rückseitenmetallisierung (M1) die ersten und vierten gemeinsamen Bereiche verbindet.

7. Monolithisches bidirektionales Schutzbauteil nach Anspruch 3,
dadurch gekennzeichnet, daß:
- die Vertikalthyristoren (T1, T2), von der Rückseite des Plättchens ausgehend, aufweisen: einen ersten gemeinsamen Bereich (P3) vom ersten Leitfähigkeitstyp, einen zweiten gemeinsamen Bereich (N2) vom zweiten Leitfähigkeitstyp, einen dritten gemeinsamen Bereich (P1) vom ersten Leitfähigkeitstyp sowie an der Oberfläche austretende distinkte gesonderte Bereiche (N11, N12) vom zweiten Leitfähigkeitstyp;
- die Lateraldioden an der Vorderseite einen vierten gemeinsamen Bereich (N4) vom zweiten Leitfähigkeitstyp mit erhöhtem Dotierungspegel aufweisen sowie in dem zweiten gemeinsamen Bereich (N2) gebildete distinkte gesonderte Bereiche (P21, P22) vom ersten Leitfähigkeitstyp;
- die ersten Vorderseitenmetallisierungen (Al, A2) einen distinkten gesonderten Bereich eines Thyristors mit einem distinkten gesonderten Bereich einer Diode und den anderen distinkten gesonderten Bereich eines Thyristors mit dem anderen gesonderten Bereich einer Diode verbinden;
- auf dem vierten gemeinsamen Bereich eine zweite Metallisierung gebildet ist; und
- eine Rückseitenmetallisierung zur Verbindung mit der zweiten Metallisierung vorgesehen ist.

## Claims

1. A bidirectional protection component between two terminals (A1, A2) comprising, in series between said terminals, two reverse connected thyristors (T1, T2), each of which is in anti-parallel with a diode (D1, D2), and having interconnected gates, characterized in that a first thyristor (T1) is turned on when the voltage across the two thyristors exceeds the sum of the avalanche voltage of the reverse-biased gate-cathode diode of the second thyristor (T2) plus the forward voltage of the gate-cathode diode of the first thyristor (T1), and vice-versa.

2. A bidirectional monolithic protection component according to claim 1, wherein the two thyristors (T1, T2) and the two diodes (D1, D2) are of vertical type, characterized in that the semiconductor regions (P3, N2, P1) constituting said thyristors are common except for their cathode regions (N11, N12), this component having three metallizations: a rear surface metallization (M1) connecting the common anodes of the thyristors with the cathodes of the diodes, a first front surface metallization (A1) connecting the cathode (N11) of a thyristor to the anode (P21) of a diode, and a second front surface metallization (A2) connecting the cathode (N12) of the other thyristor to the anode (P22) of the other diode.

3. A bidirectional monolithic protection component according to claim 1, wherein the two thyristors (T1, T2) are of the vertical type and the two diodes (D1, D2) are of the lateral type, characterized in that the semiconductor regions constituting said thyristors are common except for their cathode regions (N11, N12), this component having four metallizations: a rear surface metallization (M1), a first front surface metallization (A1) connecting the cathode of a thyristor to the anode of a diode, a second front surface metallization (A2) connecting the cathode of the other thyristor to the anode of the other diode, and a third front surface metallization (A3) in contact with the anode region of the diodes, said third front surface metallization being intended to be connected to the rear surface metallization.

4. A bidirectional protection component according to claim 2 or 3, characterized in that the cathode regions of said two thyristors have distinct doping levels.

5. A bidirectional protection component according to claim 2 or 3, characterized in that said anode region (P21) of said first diode, respectively of said second diode (P22), connected to the cathode region (N11) of the first thyristor (T1), respectively of the second thyristor (T2), comprises an extension extending in front of the cathode region (N12) of the second, respectively first, thyristor.

6. A bidirectional protection component according to claim 2, characterized in that;
the vertical thyristors (T1, T2) comprise, from the rear surface of the wafer, a first common region (P3) of a first conductivity type, a second common region (N2) of the second conductivity type, a third common region (P1) of the first conductivity type and, first distinct regions (N11, N12) of the second conductivity type appearing on the front surface;
the vertical diodes comprise, from the rear surface to the front surface, a fourth common region (N3) of the second conductivity type, the second common region (N2) and second distinct regions (P21, P22) of the first conductivity type;
front surface metallizations (Al and A2) connect a distinct region of a thyristor to a distinct region of a diode and the other distinct region of a thyristor to the other distinct region of a diode, and a rear surface metallization (M1) connects said first and fourth common regions.

7. A bidirectional monolithic protection component according to claim 3, characterized in that:
the vertical thyristors (T1, T2) comprise, from the rear surface of the wafer, a first common region (P3) of the first conductivity type, a second common region (N2) of the second conductivity type, a third common region (P1) of the first conductivity type, and distinct regions (N11, N12) of the second conductivity type appearing on the front surface;
the lateral diodes comprise, on the front surface side, a fourth highly doped common region (N4) of the second conductivity type and distinct regions (P21, P22) of the first conductivity type formed in said second common region (N2);
first front surface metallizations (A1, A2) connect a distinct region of a thyristor with a distinct region of a diode and the other distinct region of a thyristor with the other distinct region of a diode;
a second metallization is formed on the fourth common region; and
a rear surface metallization is provided to be connected to said second metallization.
